Europäisches Patentamt

European Patent Office

Office européen des brevets

(19)

(11) Publication number: **0 032 046**
**B1**

## (12) EUROPEAN PATENT SPECIFICATION

(45) Date of publication of patent specification: **12.10.83**

(21) Application number: **80304702.6**

(22) Date of filing: **23.12.80**

(51) Int. Cl.³: **H 01 L 27/02, H 02 H 9/04**

(54) Circuitry for protecting a semiconductor device against static electricity.

(30) Priority: **27.12.79 JP 169181/79**

(43) Date of publication of application:
**15.07.81 Bulletin 81/28**

(45) Publication of the grant of the patent:
**12.10.83 Bulletin 83/41**

(84) Designated Contracting States:
**DE FR GB NL**

(56) References cited:
**DE - A - 2 951 421**
**GB - A - 1 438 232**
**US - A - 4 131 908**

**IBM TECHNICAL DISCLOSURE BULLETIN, vol. 15, no. 12, May 1973 NEW YORK (US) H. L. KALTER: "Semiconductor Chip Pad Protect Device" pages 3573—3574**

(73) Proprietor: **FUJITSU LIMITED**
**1015, Kamikodanaka Nakahara-ku**
**Kawasaki-shi Kanagawa 211 (JP)**

(72) Inventor: **Kokado, Masayuki**
**3796-1, Ikuta Tama-ku**
**Kawasaki-shi Kanagawa, 214 (JP)**
Inventor: **Sumi, Hedezi**
**46-10 Shiratoridai Midori-ku**
**Yokohama-shi Kanagawa, 227 (JP)**

(74) Representative: **Fane, Christopher Robin King et al,**
**HASELTINE LAKE & CO. Hazlitt House 28**
**Southampton Buildings Chancery Lane**
**London, WC2A 1AT (GB)**

Circuitry for protecting a semiconductor device against static electricity

The present invention relates to semiconductor devices such as bipolar integrated circuits, and their protection against damaging effects of static electricity. More particularly the invention relates to a semiconductor device having protective circuitry for protecting an internal circuit of the device against electrostatic damage, the protective circuitry being connected between an electrical reference potential point of the said internal circuit and a signal input point thereof. Such a device is known, for example, from United States Patent Specification No. 4,131,908.

Generally, accompanied by the developments in Large Scale Integrated (LSI) circuits, the bipolar elements in bipolar integrated circuits are miniaturized further year by year. As the bipolar elements are further miniaturized, they become more susceptible to damage by static electricity which is almost inevitably introduced upon handling of the element.

To reduce the danger of such electrostatic damage, a circuit construction can be used in which the cathode of a diode is connected between an input pad of the integrated circuit and an input transistor, for example, the anode of the diode being connected to a power source for the device. The input transistor of a CML (Current Mode Logic) or ECL (Emitter Coupled Logic) circuit which is required to provide high performance, is generally an NPN-transistor. When a positive electrostatic pulse is applied to the input pad, the input transistor is not destroyed by the electrostic pulse since the electrostatic pulse is in the forward direction with respect to the base-collector junction of the input transistor. However, when a negative electrostatic pulse is applied to the input pad, the input transistor is reverse-biased and, if the above diode is not provided, the junction of the input transistor may be destroyed if the electrostatic pulse is large. In a case where the above diode is connected, however, the diode becomes active when a negative electrostatic pulse is applied to the input pad, and the large instantaneous current which flows at the initial stage, when the negative electrostatic pulse is applied, flows toward the input pad through the diode. In this way destruction of the input transistor can be prevented.

However, as higher demands are put upon the performance of the integrated circuit itself, the protective circuitry described above can prove inadequate. For example, since a relatively large voltage can exist between the terminals of the diode, owing to its internal resistance, when large instantaneous current flows initially upon application of an electrostatic pulse, the destruction-preventing effect may be insufficient and the input transistor could possibly be destroyed. To reduce this danger a diode having a large surface area should be used, in order to reduce the internal resistance of the diode. However, this type of a diode, having large surface area, comprises a large junction capacitance. Accordingly, when this type of a diode is used, although the internal resistance of the diode is small, the input signal waveform is distorted owing to the large junction capacitances of the diode. This is disadvantageous in that it detracts from highspeed operation of the integrated circuit.

Hence, to take account of upgrading in the high performance of integrated circuits, improved protective measures against electrostatic destruction are highly desirable.

According to the present invention there is provided a semiconductor device having protective circuitry for protecting an internal circuit of the device against electrostatic damage, the protective circuitry being connected between an electrical reference potential point of the said internal circuit and a signal input point thereof, characterized in that the said protective circuitry comprises a PNP-transistor having its emitter connected to the said electrical reference potential point; and an NPN-transistor having its emitter connected to the said signal input point of the internal circuit, and having its collector connected to the base of the PNP-transistor, and having its base connected to the collector of the PNP-transistor; there being a resistive connection between the base of the PNP-transistor and the base of the NPN-transistor.

Reference will now be made, by way of example, to the accompanying drawings in which:—

Figure 1 is an equivalent circuit diagram of part of a semiconductor device embodying the present invention;

Figure 2 is a graph showing a voltage versus current characteristic of the device of Figure 1;

Figure 3 is a circuit diagram for explaining capacitance distribution in part of the device of Figure 1; and

Figure 4 is a diagrammatic cross-sectional view of part of the semiconductor device of Figure 1.

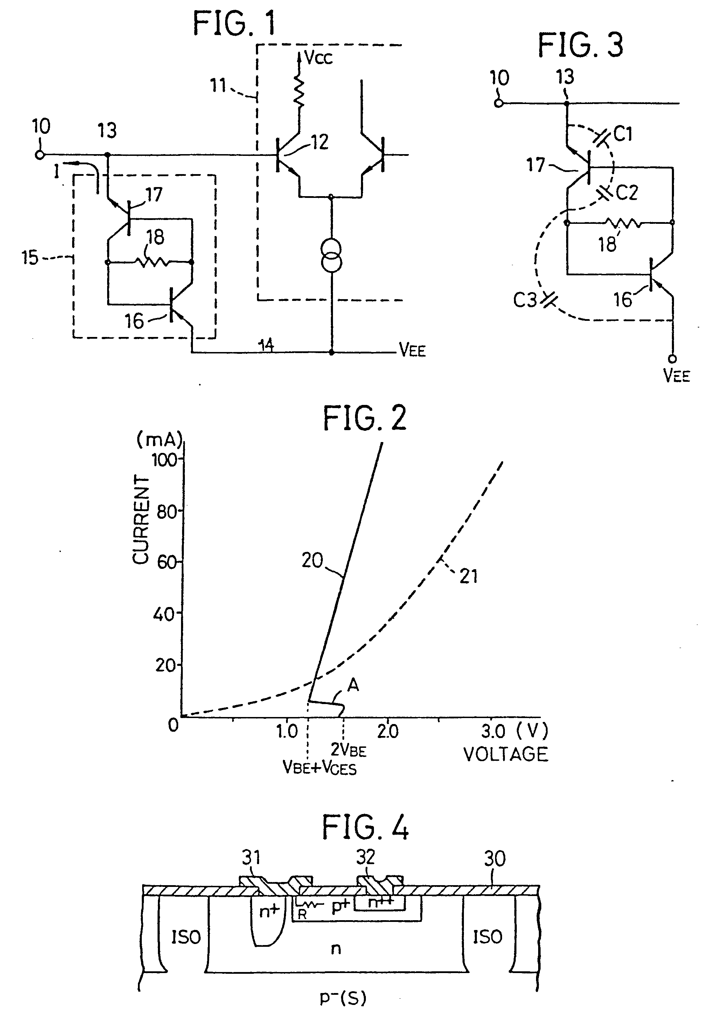

In Figure 1, an electrostatic destruction preventing circuit 15, which constitutes protective circuitry of the illustrated semiconductor device, is connected between a point 13 and a point on an electrical reference potential line 14, the point 13 being located between the base of an input NPN-transistor 12, of an internal circuit 11 of the device, and an input terminal 10 thereof. The electrostatic destruction preventing circuit 15 comprises a PNP-transistor 16, an NPN-transistor 17, and a resistance 18. The line 14 is connected to a most negative output point of a power supply (not otherwise illustrated). In practice the line 14 may be constituted by a substrate of the device, as will be described hereinafter.

The emitter of the transistor 16 is connected to the line 14, and the emitter of the transistor 17 is connected to the point 13. The base of the transistor 16 is in direct connection with the collector of the transistor 17, and the base of the transistor 17 is in direct connection with the collector of the transistor 16. The resistance 18 provides a connection between the respective bases of the transistors 16 and 17.

When a positive electrostatic pulse is applied to the input terminal 10, relative to the line 14, the input transistor 12 is not destroyed by the positive electrostatic pulse since this is in the forward direction with respect to the base-emitter junction of the input transistor 12. However, when a negative electrostatic pulse is applied between the input terminal 10 and the line 14, in the absence of the protective circuitry 15 the input transistor 12 could be destroyed because the negative electrostatic pulse is in the reverse direction with respect to the base-collector junction of the input transistor 12. Hence, the electrostatic destruction preventing circuit 15 is provided for passing a large instantaneous current, in the direction of arrow $I$ of Figure 1, when such a negative electrostatic pulse is applied between the input terminal 10 and the line 14. The operation of this circuit 15 will be described in the following.

If the forward direction base-emitter voltages of the PNP-transistor 16 and the NPN-transistor 17 are respectively designated by $V_{BE}(PNP)$ and $V_{BE}(NPN)$, the voltage at which the circuit 15 is turned ON is $V_{BE}(PNP)+V_{BE}(NPN)=2V_{BE}$. When a negative electrostatic pulse is applied between the input terminal 10 and the line 14, and the transistor 16 is turned ON, the collector current of the transistor 16 becomes the base current of the transistor 17, and thus the transistor 17 is rapidly put in a saturated state. Upon saturation of the transistor 17, the difference between the collector voltage and the emitter voltage of the transistor 17 becomes small, and the collector-emitter voltage $(V_{CES})$ when the transistor 17 is saturated is $V_{CES}<V_{BE}(NPN)$.

The operation of the protective circuitry 15 will be described in conjunction with the characteristic shown in Figure 2. The circuitry 15 is put in an ON state by a voltage equal to $2V_{BE}$, and during the process in which the transistor 17 is thereafter becoming saturated, that is while the voltage is changing to a value equal to $V_{BE}+V_{CES}$, the characteristic of the circuitry is in a negative resistance region $A$. Beyond the point at which the transistor 17 is saturated, the internal resistance becomes small, and the current flow exhibits a very steep slope characteristic. Accordingly, when a negative electrostatic pulse is applied between the input terminal 10 and the line 14, the circuitry 15 is capable of passing a large current virtually instantly in the direction of the arrow $I$ of Figure 1. In contrast, if a simple diode were connected in place of the circuitry 15, the discharge characteristic would be a smooth curve as shown at 21 in Figure 2, owing to the bulk resistance of the diode, so that the diode would not be capable of allowing the current to flow so rapidly as the circuitry 15.

The capacitive component of the circuit 15 will now be discussed with reference to Figure 3. The existence of a capacitance C1 between the emitter and base of the transistor 17, a capacitance C2 between the collector and base of the transistor 17, and a capacitance C3 between the collector of the transistor 17 and its isolation, can be considered as seen in Figure 3. The sum $C$ of the above capacitances is determined by using the relationship

$$\frac{1}{C}=\frac{1}{C1}+\frac{1}{C2}+\frac{1}{C3}$$

so the sum $C$ of the capacitances is smaller than the smallest of the three capacitances C1, C2, and C3. The transistor 16 comprises capacitive components similar to those of the transistor 17. It can accordingly be seen that the sum of all the capacitive components in the circuitry 15 is of a small value, and indeed such an embodiment of the invention is possible in which highspeed operation of the internal circuit 11 is practically unaffected by the use, and in particular the capacitive components, of the protective circuitry 15.

The physical structure of the semiconductor device of Figure 1 will now be described in more detail in conjunction with the cross-sectional diagram of Figure 4. As shown in Figure 4, an n-type layer, an $n^+$-type region, a $p^+$-type region, and an $n^{++}$-type region are formed within a region surrounded by an isolation region ISO which is formed on a $p^-$-type substrate $p^-(S)$. An oxidized insulation layer 30 made of silicon dioxide ($SiO_2$), is formed on top of the above layers as shown in Figure 4. The substrate $p^-(S)$ is connected to a most negative output $V_{EE}$ of a power supply for the device.

The said substrate $p^-(S)$, n-type layer, and $p^+$-type region respectively provide the emitter, base, and collector of the transistor 16, while said n-type layer, $p^+$-type region and $n^{++}$-type region respectively provide the collector, base, and emitter of the transistor 17. Accordingly, said n-type layer is simultaneously used as the base of the transistor 16 and collector of the transistor 17, and the said $p^+$-type region is simultaneously used as the collector of the transistor 16 and the base of the transistor 17. An electrode 31 forms an external conductive wiring to interconnect (short-circuit) the base and collector of the transistor 17. Resistance $R$ indicated inside the said $p^+$-type region is the external base resistance of the transistor 17, and corresponds to the resistance 18 of Figures 1 and 3. An electrode 32 serves to connect the $n^{++}$-type region, which forms the emitter of the transistor 17, to the input terminal 10 of Figure 2.

The circuitry as illustrated in Figure 4 is constructed so as to provide vertical PNPN-operation, thereby enabling the series resistance component of the circuitry to be desirably small. Accordingly, as described above, the large instantaneous current introduced when a negative electrostatic pulse is applied can rapidly be passed through.

## Claims

1. A semiconductor device having protective circuitry (15) for protecting an internal circuit (11) of the device against electrostatic damage, the protective circuitry being connected between an electrical reference potential point (14) of the said internal circuit and a signal input point (10) thereof, characterized in that the said protective circuitry comprises a PNP-transistor (16) having its emitter connected to the said electrical reference potential point (14); and an NPN-transistor (17) having its emitter connected to the said signal input point (10) of the internal circuit (11), and having its collector connected to the base of the PNP-transistor (16), and having its base connected to the collector of the PNP-transistor (16); there being a resistive connection (18) between the base of the PNP-transistor (16) and the base of the NPN-transistor (17).

2. A semiconductor device as claimed in claim 1, wherein the said electrical reference potential point (14) is connected to a most negative output point ($V_{EE}$) of a power supply when the device is in use.

3. A semiconductor device as claimed in claim 1 or 2, further characterized in that the PNP-transistor (16) has its emitter provided by a p-type substrate, its base provided by an n-type layer, and its collector provided by a p-type region of the device, and the NPN-transistor (17) has its collector provided by the said n-type layer, its base provided by the said p-type region, and its emitter provided by an n-type region of the device, the said n-type layer being connected to the said p-type region by conductive means provided externally of the device.

4. A semiconductor device as claimed in claim 3, wherein the said n-type region overlies part of the said p-type region which overlies part of the said n-type layer which overlies part of the said p-type substrate so that the protective circuitry is characterized by vertical PNPN operation.

5. A semiconductor device as claimed in claim 1, 2, 3 or 4, wherein the said protective circuitry (15) is so fabricated that it has a voltage versus current characteristic which includes a negative resistance portion corresponding to saturation of the said NPN-transistor (17).

6. A semiconductor device as claimed in any preceding claim, characterized in that it comprises a bipolar integrated circuit wherein the said internal circuit (11) includes an NPN input transistor (12) having its base connected to the said signal input (10).

## Revendications

1. Dispositif semi-conducteur comprenant un circuit de protection (15) pour protéger un circuit intérieur (11) du dispositif contre les dommages électrostatiques, le circuit de protection étant connecté entre un point de potentiel de référence électrique (14) dudit circuit intérieur et son point d'entrée de signaux (10), caractérisé en ce que ledit circuit de protection comporte un transistor PNP (16) dont l'émetteur est connecté audit point de potentiel de référence électrique (14) et un transistor NPN (17) dont l'émetteur est connecté audit point d'entrée de signaux (10) du circuit intérieur (11), dont le collecteur est connecté à la base du transistor PNP (16) et dont la base est connectée au collecteur du transistor PNP (16), une connexion résistive (18) étant prévue entre la base du transistor PNP (16) et la base du transistor NPN (17).

2. Dispositif semi-conducteur selon la revendication 1, dans lequel ledit point de potentiel de référence électrique (14) est connecté au point de sortie le plus négatif ($V_{EE}$) d'une source d'alimentation quand le dispositif est utilisé.

3. Dispositif semi-conducteur selon la revendication 1 ou 2, caractérisé en ce que l'émetteur du transistor PNP (16) est constitué par un substrat de type P, sa base étant constituée par une couche de type N et son collecteur étant constitué par une région de type P du dispositif, le collecteur du transistor NPN (17) étant formé par ladite couche de type N, sa base étant formée par ladite région de type P et son émetteur étant formé par une région de type N du dispositif, la couche de type N étant connectée à ladite région de type P par un dispositif conducteur, à l'extérieur du dispositif.

4. Dispositif semi-conducteur selon la revendication 3, dans lequel ladite région de type N recouvre une partie de ladite région de type P qui recouvre une partie de ladite couche de type N qui recouvre une partie dudit substrat de type P de manière que le circuit de protection de caractérisé par un fonctionnement PNPN vertical.

5. Dispositif semi-conducteur selon la revendication 1, 2, 3 ou 4, dans lequel ledit circuit de protection (15) est réalisé de manière que sa caractéristique de tension en fonction du courant comprend une partie de résistance négative qui correspond à la saturation dudit transistor NPN (17).

6. Dispositif semi-conducteur selon l'une quelconque des revendications précédentes, caractérisé en ce qu'il comporte un circuit intégré bipolaire dans lequel ledit circuit intérieur (11) comprend un transistor d'entrée NPN (12) dont la base est connectée audit point d'entrée de signaux (10).

**Patentansprüche**

1. Halbleiteranordnung mit einer Schutzschaltung (15) zum Schutz einer internen Schaltung (11) gegen elektrostatische Beschädigung, bei welcher die Schutzschaltung zwischen einem elektrischen Referenzpotentialpunkt (14) der genannten internen Schaltung und einem Signaleingangspunkt (19) derselben angeordnet ist, dadurch gekennzeichnet, daß die genannte Schutzschaltung einen PNP-Transistor (16) umfaßt, dessen Emitter mit dem genannten elektrischen Referenzpotentialpunkt (14) verbunden ist, und einen NPN-Transistor (17), dessen Emitter mit dem genannten Signaleingangspunkt (10) der internen Schaltung (11) verbunden ist, dessen Kollektor mit der Basis der PNP-Transistors (16) verbunden ist und dessen Basis mit dem Kollektor des PNP-Transistors (16) verbunden ist, wobei eine ohmsche Verbindung (18) zwischen der Basis des PNP-Transistors (16) und der Basis des NPN-Transistors (17) vorgesehen ist.

2. Halbleiteranordnung nach Anspruch 1, bei welcher der genannte elektrische Referenzpotentialpunkt (14) mit dem am stärksten negativen Ausgangspunkt ($V_{EE}$) einer Energieversorgungseinrichtung verbunden ist, wenn die Vorrichtung in Betrieb ist.

3. Halbleiteranordnung nach Anspruch 1 oder 2, dadurch gekennzeichnet, daß der Emitter des PNP-Transistors (16) durch ein P-leitendes Substrat gebildet ist, seine Basis durch eine N-leitende Schicht gebildet ist und sein Kollektor durch eine P-leitende Zone der Vorrichtung gebildet ist, daß der Kollektor des NPN-Transistors (17) durch die N-leitende Schicht, seine Basis durch die P-leitende Zone und sein Emitter durch eine N-leitende Zone der Vorrichtung gebildet ist und die N-leitende Schicht mit der genannten P-leitenden Zone durch eine leitende Einrichtung verbunden ist, welche außerhalb der Vorrichtung vorgesehen ist.

4. Halbleiteranordnung nach Anspruch 3, bei welcher die genannte N-leitende Zone über einem Teil der genannten P-leitenden Zone liegt, welche über einem Teil der genannten N-leitenden Schicht liegt, welche über einem Teil des P-leitenden Substrats liegt, so daß die Schutzschaltung durch einen vertikalen PNPN-Betrieb gekennzeichnet ist.

5. Halbleiteranordnung nach einem der Ansprüche 1, 2, 3 oder 4, bei welcher die genannte Schutzschaltung (15) so hergestellt ist, daß ihre Spannung/Strom-Charakteristik einen negativen Widerstandsabschnitt umfaßt, welcher der Sättigung des genannten NPN-Transistors (17) entspricht.

6. Halbleiteranordnung nach einem der vorhergehenden Ansprüche, dadurch gekennzeichnet, daß sie eine bipolare integrierte Schaltung umfaßt, in welcher die genannte interne Schaltung (11) einen NPN-Eingangstransistor (12) umfaßt, dessen Basis mit dem genannten Signaleingangspunkt (10) verbunden ist.

0 032 046

FIG. 1

FIG. 3

FIG. 2

FIG. 4